**Europäisches Patentamt**

**European Patent Office**

**Office européen des brevets**

(11) Veröffentlichungsnummer : **0 078 511 B2**

# (12) NEUE EUROPÄISCHE PATENTSCHRIFT

(45) Veröffentlichungstag der neuen Patentschrift :
07.08.91 Patentblatt 91/32

(21) Anmeldenummer : 82109985.0

(22) Anmeldetag : 28.10.82

(51) Int. Cl.⁵ : **H03K 17/95**

(54) **Elektronischer Näherungsschalter.**

(30) Priorität : 30.10.81 JP 174009/81
26.11.81 JP 188364/81

(43) Veröffentlichungstag der Anmeldung :
11.05.83 Patentblatt 83/19

(45) Bekanntmachung des Hinweises auf die
Patenterteilung :
19.08.87 Patentblatt 87/34

(45) Bekanntmachung des Hinweises auf die
Entscheidung über den Einspruch :
07.08.91 Patentblatt 91/32

(84) Benannte Vertragsstaaten :
CH DE FR GB IT LI

(56) Entgegenhaltungen :
DE-A- 2 435 501
FR-A- 2 348 604

(56) Entgegenhaltungen :
FR-A- 2 368 049
US-A- 3 524 997
US-A- 4 168 443
S.W. Wagner: "Stromversorgung elektronischer Schaltungen und Geräte" Hamburg
1964, Seiten 492-497

(73) Patentinhaber : FUJI ELECTRIC CO. LTD.
1-1, Tanabeshinden, Kawasaki-ku
Kawasaki 210 (JP)

(72) Erfinder : Tanigawa, Kiyoshi, Dipl-Ing.
4-3-24, Fujimi Fukiage-machi
Kita-Adachigun Saitama (JP)
Erfinder : Takahashi, Fumito
5108-14, Saitama Giyoda-shi
Saitama (JP)

(74) Vertreter : Fuchs, Franz-Josef, Dr.-Ing. et al
Postfach 22 13 17
W-8000 München 22 (DE)

EP 0 078 511 B2

**Beschreibung**

Die Erfindung bezieht sich auf einen elektronischen Näherungsschalter mit einer mit der Last in Reihe liegenden Spannungsversorgung und einem steuerabhängig von einem Ansprechkreis die Reihenschaltung kurzschließenden, elektronischen Schalter und einer Speiseschaltung zur Erzeugung einer Hilfsspannung für den Ansprechkreis, bestehend aus einem parallel zur Spannungseinspeisung des Ansprechkreises liegenden elektronischen Spannungsregler, wobei die Reihenschaltung aus Kondensator und Spannungsregler parallel zum elektronischen Schalter liegt.

Bei einem bekannten Näherungsschalter der obengenannten Art (DE-OS 24 35 501) wird der elektronische Schalter, in diesem Falle ein Thyristor oder Triac, mit einem Phasenwinkel größer als Null betrieben und sowohl im leitenden als auch im gesperrten Zustand eine Hilfsspannung für den Oszillator abgeleitet und durch einen Regler konstant gehalten. Bei diesem bekannten Näherungsschalter ist weder eine von der Kondensatorspannung abhängige Phasenwinkelregelung noch eine direkte Regelverbindung zum elektronischen Schalter vorhanden. Der Erfindung liegt somit die Aufgabe zugrunde, einen Näherungsschalter zu schaffen, der in bezug auf die Versorgungsspannung mit relativ geringer Spannung bei geringen Verlusten vielseitig anwendbar ist. Diese Aufgabe wird bei einem Näherungsschalter der obengenannten Art auf einfache Weise dadurch gelöst, daß die Spannungsversorgung als kontinuierliche Gleichspannung ausgebildet ist, daß eine die Kondensatorspannung erfassende Vergleichsschaltung mit dem Steueranschluß des als Transistor ausgeführten elektronischen Schalters in Wirkverbindung steht und die Vergleichsschaltung bei Unterschreiten einer vorbestimmten unteren Kondensatorspannung den Transistor bis zum Erreichen einer vorbestimmten oberen Kondensatorspannung sperrt. Um ein zu häufiges Schalten des elektronischen Schalters während des Betriebes zu vermeiden ist es vorteilhaft, wenn die Vergleichsschaltung mit einer Hystereseschaltung versehen ist. Eine einfache Schaltungsausführung ergibt sich, wenn die Vergleichsschaltung aus einer Reihenschaltung von Widerstand, Zenerdiode und Basis-Emitter-Strecke des Transistors besteht, zu dessen Emitter-Kollektor-Strecke die Reihenschaltung eines weiteren Widerstandes mit der Emitter-Basis-Strecke eines zweiten Transistors liegt, wobei parallel zu dem weiteren Widerstand die Emitter-Basis-Strecke eines Ausgangstransistors liegt, dessen Kollektor am Steuereingang des Transistors liegt und bei der der Kollektor des einen mit der Basis des weiteren Transistors und dieser Verbindungspunkt über einen Widerstand am Eingang der Vergleichsschaltung liegt, der seinerseits über einen Widerstand am Kollektor des weiteren Transistors angeschlossen ist, wobei dieser Verbindungspunkt über einen Widerstand am Verbindungspunkt zwischen Widerstand und Zenerdiode liegt. Auf ein zusätzliches Spannungsnormal in Form der Zenerdiode für den Spannungsregler kann verzichtet werden, wenn die Vergleichsschaltung einerseits an der Basis eines den Spannungsregler bildenden Transistors und andererseits am Minuspol der Speiseschaltung liegt. Um die Möglichkeit zu schaffen, den erfindungsgemäßen Näherungsschalter bei geringem Leckstrom auch als Dreidrahtnäherungsschalter zu verwenden ist es weiterhin vorteilhaft, wenn zwischen Spannungsregler und Transistor eine Diode geschaltet und der Verbindungspunkt zum Spannungsregler nach außen geführt ist. Zur Anzeige des Betriebszustandes ist es weiterhin von Vorteil, wenn zwischen Diode und Spannungsregler eine Lumineszenzdiode (LED) mit parallel liegendem Widerstand geschaltet ist.

Anhand der Zeichnung werden Ausführungsbeispiele gemäß der Erfindung beschrieben und die Wirkungsweise näher erläutert.

Es zeigen

Figur 1 eine Schaltungsanordnung mit einer vergleichsschaltung und zusätzlichem Konstantspannungselement,

Figur 2 Stromdiagramme der Versorgungsströme

Figur 3 die Schaltungsanordnung nach Fig. 1 ohne zusätzliches Konstantspannungselement,

Figur 4 eine Schaltungsausführung für 3-Drahtanschluß und

Figur 5 eine Schaltungsanordnung nach Fig. 4 mit einer LED-Anzeige.

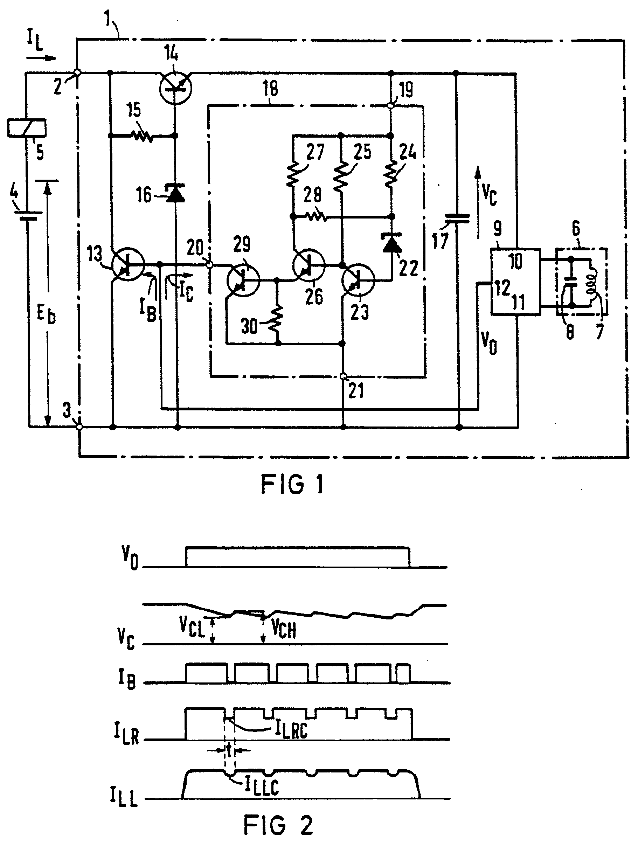

Die in Fig. 1 dargestellte Schaltung des Näherungsschalters 1 weist Klemmen 2 und 3 auf, an die eine Spannungsquelle 4 und eine Last 5, beispielsweise ein Relais, angeschlossen sind. Ein Erfassungskreis 6 besteht aus der Ansprechspule 7 und dem Kondensator 8. Mit einem Ansprechkreis 9 sind die Ansprechspule 7 und der Kondensator 8 sowie Spannungsversorgungsklemmen 10 und 11 verbunden. Der Steuerausgang ist mit 12 bezeichnet. Ein Transistor 13 ist mit dem Kollektor und dem Emitter an die Klemmen 2 und 3 des Näherungsschalters 1 angeschlossen. Die Basis des Transistors ist mit dem Steuerausgang 12 des Ansprechkreises 9 verbunden. Der Kollektor des Transistors 14 zusammen mit einem Anschluß des Widerstandes 15 liegt gleichfalls an der Klemme 2. Die Basis des Transistors 14 mit dem anderen Anschluß des Widerstandes 15 liegen an der Kathode des Konstantspannungselementes 16, einer Zenerdiode, und sein Emitter liegt an der Spannungsversorgungsklemme 10 des Ansprechkreises 9. Die Anode des Konstantspannungselementes 16 ist an der Klemme 3 angeschlossen. Mit dem Konstantspannungskreis, der aus dem Transistor 14, dem Widerstand 15 und dem Konstantspannungselement 16 besteht, kann die an der

Spannungsversorgungsklemme 10 des Ansprechkreises 9 liegende Spannung im wesentlichen gleich hoch bleiben wie die Nennspannung des Konstantspannungselementes 16, wenn der Transistor 13 abgeschaltet ist.

Ein Kondensator 17 ist zwischen die Spannungsversorgungsklemmen 10, 11 des Ansprecchkreises 9 eingeschaltet. Weiterhin zeigt Fig. 1 eine vergleichsschaltung 18, die mit der Spannungseingangsklemme 19 an der positiven Seite des Kondensators 17 angeschlossen ist. Eine Ausgangsklemme 20 liegt an des Basis des Transistors 13 und die Minusklemme 21 liegt an der Klemme 3. Die Anode eines Konstantspannungselementes 22 ist mit der Basis des Transistors 23, die Kathode mit der Spannungseingangsklemme 19 über den Widerstand 24 verbunden ist. Der Emitter des Transistors 23 liegt an der Klemme 21 und sein Kollektor an der Spannungseingangsklemme 19 über den Widerstand 25 und gleichzeitig an der Basis des Transistors 26. Der Kollektor des Transistors 26 liegt an der Klemme 19 über den Widerstand 27 und an der Kathode des Konstantspannungselementes 22 über den Widerstand 28. Der Emitter des Transistors 26 liegt an der Basis des Transistors 29 und an der Klemme 21 über den Widerstand 30. Der Kollektor des Transistors 29 liegt an der Ausgangsklemme 20 und sein Emitter an der Minusklemme 21.

Bezugnehmend auf Fig. 2 wird die Funktion des Näherungsschalters wie folgt beschrieben :

Solange sich ein zu überwachendes Objekt weit von der Ansprechspule 7 entfernt befindet, wird kein Ausgangssignal an dem Steuerausgang 12 des Ansprechkreises 9 anliegen und der Transistor 13 ist im Aus-Zustand. Zu dieser Zeit fließt Strom von der Spannungsquelle 4 über die Klemme 10 des Ansprechkreises 9 und die Last 5 sowie den Transistor 14 und die versorgungsspannung wird konstant gehalten auf einem Wert, der leicht höher ist als der, der an dem Konstantspannungselement 16 zu verzeichnen ist. Zusätzlich wird eine interne Impedanz, gesehen von der Spannungsversorgungsklemme 10 des Erfassungskreises und eine, von der Klemme 19 der vergleichsschaltung 18 gesehen, entsprechend groß zu betrachten sein, so daß die Last 5 durch den Stromfluß nicht ansprechen kann. Weiterhin wird sich die Blockspannung des Serienkreises, der aus dem Konstantspannungselement 22 der Basis-Emitter-Strecke des Transistors 23 besteht, geringfügig kleiner gestalten als die Nennspannung des Konstantspannungselementes 16, so daß, wenn der Transistor 13 im Aus-Zustand ist, weil sich das Objekt, das überwacht werden soll, weit weg von der Ansprechspule 7 befindet, die an der Spannungseingangsklemme 19 anliegende Spannung die Block-spannung überschreitet, um den Transistor 23 leitend zu machen, so daß die Transistoren 26 und 29 abhängig vom Transistor 23 in die Ausstellung gelangen.

Sobald das zu überwachende Objekt näher an die Ansprechspule 7 herankommt, wird eine vorbestimmbare Ausgangsspannung an der Klemme 12 des Ansprechkreises 9 anstehen. Da der Transistor 29 undurchlässig ist, fließt der Strom IB zur Basis des Transistors 13 und verursacht dessen Durchschaltung. Ab diesem Zeitpunkt steht eine Betriebsspannung, die ungefähr gleich der Spannung $E_b$ der Spannungsquelle 4 ist, an der Last 5 an, die dann betrieben wird. Auf der anderen Seite wird die Kollektorspannung des Transistors 14 niedriger als seine Basisspannung, da der Transistor 13 leitet, so daß der Strom, der an der Spannungsversorgungsklemme 10 der Ansprechkreises 9 liegt, ausgeschaltet wird. Dann fließt der Entladestrom des Kondensators 17 in den Ansprechkreis 9 und die vergleichsschaltung 18, was eine Spannungsabsenkung der Klemmenspannung $V_C$ des Kondensators 17 bewirkt. Hierdurch wird die Klemmenspannung $V_C$ niedriger als die Blockspannung in dem Reihenkreis, der aus der Reihenschaltung des Konstantspannungselementes 22 der Vergleichsschaltung 18 und der Basis-Emitter-Strecke des Transistors 23 besteht. Der Transistor 23 geht in den Sperrzustand. Abhängig vom Transistor 23 gehen die Transistoren 26, 29 in den leitenden Zustand über. Sobald der Transistor 29 leitend wird, erhält der Strom von der Klemme 12 des Ansprechkreises 9 zum Transistor 13 einen Beipaß, so daß der Transistor 13 abgeschaltet wird. Als Ergebnis hiervon wird die Kollektorspannung des Transistors 14 wieder hergestellt und der Strom fließt über den Kondensator 17 und die Spannungsversorgungsklemme 10 des Ansprechkreises 9 durch die Kollektor-Emitter-Strecke des Transistors. Die Klemmenspannung des Kondensators 17 steigt entsprechend der Zeitkonstante, die von der Kapazität des Kondensators und dem Widerstand der Last 5, dem Transistor 14, dem Ansprechkreis 9, der Vergleichsschaltung 18 und weiteren abhängt. Wenn die Spannung $V_C$ des Kondensators 17 wieder einen vorbestimmbaren Wert erreicht hat, fließt Strom zur Basis des Transistors 23, der wiederum leitend wird. Die Transistoren 26 und 29 hören abhängig vom Transistor auf, leitend zu sein, wodurch der Strom, der von dem Steuerausgang 12 des Ansprechkreises ausgeht und einen Beipaß durch den Transistor 29 hat, wieder zur Basis des Transistors 13 fließen kann. Sobald dieser Transistor leitet, kommt der Transistor 14 in den Sperrzustand, was sich mehrfach wiederholt.

Die vergleichsschaltung 18 ist mit einer Hysterese ausgestattet. Mit anderen Worten : Wenn der Transistor 26 leitet und zwar in Abhängigkeit vom Transistor 23, der nicht leitend wurde, fließt der Kollektorstrom nicht nur durch den Widerstand 27, son-dern auch durch die Widerstände 24 und 28. Entsprechend wird auch, wenn die Klemmenspan-nung $V_C$ des Kondensators 17 auf eine Spannung gestiegen ist, die den Transistor 23 auszuschalten veranlaßt - das ist die sogenannte Blockspannung (niederer Grenzwert $V_{CL}$) an der Serienschaltung, bestehend aus dem Konstantspannungselement 22 und der Basis-Emitter-Strecke des Transistors 23—, wird der Transistor 23 nicht leitend, bevor die Klemmenspannung $V_C$ des Kondensators 17 auf einen Spannungswert gestiegen ist (oberer Grenzwert $V_{CH}$), der aus einem Mittelwert des niedrigeren Grenzwertes $V_{CL}$ und einem Spannungsabfall am Widerstand 24 besteht.

Auf diese Weise macht die vergleichsschaltung 18 den Transistor 29 leitend, wenn die an der Spannungseingangsklemme 19 anliegende Spannung niedriger ist als der niedrigere Grenzwert $V_{CL}$ und schaltet den Transistor 29 ab, wenn die an der Klemme 19 liegende Spannung auf den oberen Grenzwert $V_{CH}$ gestiegen ist. Mit anderen Worten : Die vergleichsschaltung 18 hat Hysteresecharakter. Aufgrund dieses Hysteresecharakters arbeitet die Vergleichsschaltung 18 intermittierend, um den Transistor 13 zeitweise abzuschalten, so daß der Kondensator 17 geladen wird, wenn die Klemmenspannung $V_c$ am Kondensator 17 unter den niederen Grenzwert $V_{CL}$ fällt, nachdem der Transistor 13 Strom führte und dem Transistor 13 die Stromführung wieder zu ermöglichen zu einem Zeitpunkt, wenn die Klemmenspannung $V_C$ wieder den oberen Grenzwert $V_{CH}$ erreicht hat.

Fig. 2 zeigt die Ströme $I_{LL}$ und $I_{LR}$, die durch die Last 5 auch während der Zeit, in der der Transistor 13 zeitweilig abgeschaltet ist, fließen. $I_{LR}$ ist der Strom, der fließt, wenn die Last 5 eine Widerstandslast ist, wobei die Höhe des Ladestromes durch den Widerstandswert der Last 5 und den zwischen dem Kollektor und Emitter des Transistors 14, wenn er leitend ist, bestimmt ist. Der Strom fließt in den Kondensator 17 während der Ladeperiode t. Dieser Ladestrom $I_{LRC}$ ist geringfügig kleiner als der Strom $I_{LR}$, wenn der Transistor 13 leitend ist, so daß die Last 5 auch in der Periode t weiter angesprochen bleibt.

Zusätzlich zeigt $I_{LL}$ den Strom, der in der Last 5 fließt, an, wenn diese induktiv ist und der Strom $I_{LLC}$, der fast gleich ist mit dem Strom $I_{LL}$, der aufgrund der magnetischen Energie in der Last 5 bei leitendem Transistor 13 fließt, sorgt dafür, daß die Last 5 in Betrieb bleibt.

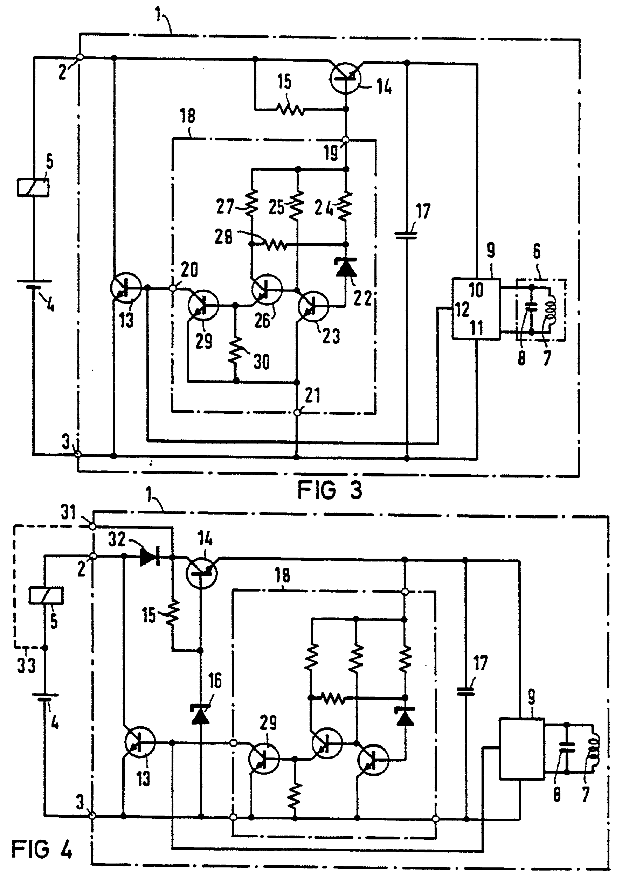

Fig. 3 zeigt ein weiteres Beispiel der vorliegenden Erfindung. Hier entfällt das Konstantspannungselement 16 in dem Konstantspannungskreis gemäß Fig. 2. Die Spannungseingangsklemme 19 der Vergleichsschaltung 18 ist mit der Basis des Transistors 14 verbunden. Somit ist das Konstantspannungselement 22 für die Spannungserfassung innerhalb der vergleichsschaltung 18 ebenso verwendbar als Konstantspannungselement in dem Konstantspannungskreis. In diesem Beispiel ist die Änderung der Klemmenspannung Vc des Kondensators 17 indirekt abgeleitet durch das Basispotential des Kondensators 17.

Wie oben erwähnt, kann die angewendete Spannung zwischen den Klemmen des Schalters entsprechend der vorliegenden Erfindung auf ein Minimum reduziert werden, wenn der Schalter leitend ist, und folglich kann die Höhe des Stromflusses in der Last nahezu dem Wert angepaßt werden, der mit einem idealen Schalter in bezug auf Kontaktgesichtspunkte erreichbar ist. Obgleich vorangehend von induktiven Schaltern die Rede war, ist es ohne weiteres möglich, den Gegenstand der Erfindung auch bei kapazitiven oder fotoelektrischen Gleichstromzweidraht-Näherungsschaltern anzuwenden.

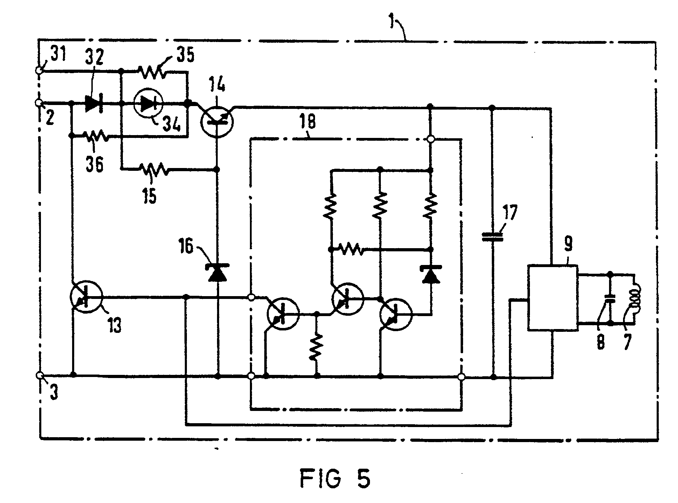

Fig. 4 zeigt eine weitere Schaltungsvariante des Näherungsschalters gemäß der Erfindung. Der Näherungsschalter hat zusätzlich zu den Klemmen 2, 3 eine weitere, die mit 31 bezeichnet ist. Die Spannungsquelle 4 ist zwischen den Klemmen 3 und 31 und die Last 5 zwischen den Klemmen 2 und 31 bei einem Dreidrahtsystem eingeschaltet, und die Reihenschaltung von Spannungsquelle 4 und Last 5 liegt zwischen den Klemmen 2 und 3, wobei die Klemme 31 offenge lassen wird oder mit der Klemme 2 verbunden wird, wenn ein Zweidrahtsystem gewünscht ist. Die Stromversorgung von der Klemme 2 zum Ansprechkreis 9, dem Konstantspannungselement 16 und dem Kondensator 17 erfolgt über eine Diode 32, die in Vorwärtsrichtung mit den, Transistor 14 eingeschaltet ist. Der Verbindungspunkt zwischen der Kathode der Diode 32 und dem Kollektor des Transistors 14 ist zur Klemme 31 geführt.

In einer solchen Zusammenschaltung ist die Funktion des Näherungsschalters in Zweidrahtausführung im wesentlichen die gleiche wie die Funktion des Schalters gemäß Fig. 1. Es ist augenscheinlich, daß die Funktion in dem Fall genau äquivalent ist, wenn die Klemmen 2 und 31 kurzgeschlossen sind.

In dem Augenblick, in dem der Näherungsschalter als Dreidrahtschalter, wie gestrichelt durch die verbindung 33 in Fig. 4 angedeutet, zusammengeschaltet ist, wird der Strom von der Spannungsquelle 4 zum Ansprechkreis 9 über einen Konstantspannungskreis, bestehend aus dem Transistor 14, dem Konstantspannungselement 16 und dem Widerstand 15 geführt, wobei die Spannung im wesentlichen von der Klemmenspannung des Konstantspannungselementes 16 abhängt. Wenn der Transistor 13 in der Einstellung ist, ist ein Stromfluß von der Spannungsquelle 4 zum Transistor 13 über die Diode 32 verhindert. In einem solchen Fall liegt aufgrund des Konstantspannungskreises (Transistor 14, Konstantspannungselement 16 und Widerstand 15) eine konstante Spannung am Ansprechkreis 9. Wird der Transistor 13 durch ein Signal vom Sensorkreis in Einstellung gesteuert, schaltet der Transistor 29 der Vergleichsschaltung 18 entsprechend nicht auf Ein, da die Spannung am Ansprechkreis 9 höher ist als die Schwellspannung der Vergleichsschaltung 18. Dadurch, daß der Transistor 13 dauernd in Einstellung bleiben kann und hierdurch kein Spannungsverlust auf dem Wege zwischen den Klemmen 2 und 3 eintritt, von der Spannungsquelle 4 aus gesehen, kann die Einspannung im vergleich zu der Zweidrahtausführung erheblich vermindert werden. Sobald der Transistor 13 ausschaltet, kann weiterhin die Diode 32 als Freilaufdiode wirken. In dem Fall, in dem die Last eine induktive Last ist, kann der Strom in der Last 5 weiterfließen, so daß hierdurch übermäßige Spannungen am Transistor 13 vermieden werden. Im Aus-Zustand des Transistors 13 kann der Leckstrom in der Last 5 im Vergleich zu der Zweidrahtverbindung, bei der der Strom für den Ansprechkreis 9 durch die Last 5 erzeugt wird, beachtlich herabgedrückt werden ; denn im vorliegenden Fall fließt lediglich der Leckstrom des Transistors 13 durch die Last 5 und alle weiteren Ströme, die von dem Ansprechkreis 9, der Vergleichsschaltung 18 benötigt werden, werden über die Klemme 31 herangeführt.

Fig. 5 zeigt eine weitere Ausführungsform der Erfindung, in der eine LED-Diode (Light emitting diode) zur Anzeige der Betriebsbedingungen vorgesehen ist. Die LED 34 ist in Vorwärtsrichtung zwischen die Klemme 31 und den Kollektor des Transistors 14, und zwar parallel zu einem Widerstand 35 eingeschaltet. Ein Widerstand 36 liegt einerseits am Verbindungspunkt der Kathode der LED 34 und dem Kollektor des Transistors 14 und andererseits an dem Kollektor des Transistors 13. Wird die Zweidrahtausführung bei einer solchen Schaltungsanordnung betrachtet, so fließt Strom über den Ansprechkreis 9 und die Vergleichsschaltung 18 über eine Parallelschaltung aus der LED 34 und den Widerstand 35, wenn der Transistor 13 im Aus-Zustand ist. Durch die genügend niedrige Wahl des Wertes für den Widerstand 35 ist der Spannungsabfall entlang des Widerstandes 35 kleiner als die Durchlaßspannung der LED, so daß die LED 34 nicht eingeschaltet ist. Da eine impulsähnliche Spannung an dem Ansprechkreis 9 und der Vergleichsschaltung 18 anstehen kann, wenn der Transistor 13 ausschaltet, schaltet der Spitzenwert des Stromes der durch den Widerstand 35 und die LED 34 fließt, die LED ein. Bei der Dreidrahtausführung wird die LED 34 nicht durch den Beipaßwiderstand 35 eingeschaltet, wenn der Transistor 13 ausschaltet, wie das bei der Zweidrahtausführung der Fall ist. Wenn der Transistor 13 einschaltet, wird hier, um LED 34 einzuschalten, Strom auf folgendem Wege fließen : Spannungsquelle 4, Klemme 31, LED 34, Widerstand 36, Transistor 13. Es ist augenscheinlich, daß die Vergleichsschaltung 18 in der Anordnung, wie sie in Fig. 4 und 5 gezeigt ist, genauso ausgeführt werden kann, wie dies in Fig. 1 oder 3 gezeugt wurde. Wie weiter oben in bezug auf die Erfindung ausgeführt wurde, kann die erfindungsgemäße Anordnung, da die Stromversorgung für den Ansprechkreis über die Diode 32 und die Klemme 31 von der Kathode der Diode 32 als Spannungsversorgungsklemme im Dreidrahtsystem abgeleitet ist, in Dreidrahtausführung benutzt werden, ohne die Funktion des Näherungsschalters in Zweidrahtausführung zu beeinträchtigen. Dementsprechend kann der Schalter unter entsprechenden Gesichtspunkten sowohl im Zweidraht- als auch im Dreidrahtsystem benutzt werden.

Ein Näherungsschalter mit Zweidrahtsystem bekannter Ausführung hat den Nachteil, daß, verglichen mit einem Näherungsschalter in Dreidrahtausführung, ein größerer Leckstrom vorhanden ist, da die Stromversorgung über die Last zum Ansprechkreis auch erfolgen muß, wenn der Ausgang unterbrochen ist. Es ist weiterhin von Nachteil, daß die Ein-Spannung, die notwendig ist um den Weg zwischen den beiden Klemmen 2 und 3 durch wiederholtes Ein- und Ausschalten des Transistors 13 leitend zu machen, höher ist, da auch Strom zum Ansprechkreis im leitenden Zustand des Ausganges geführt werden muß.

## Patentansprüche

1. Elektronischer Näherungsschalter mit einer mit der Last (5) in Reihe liegenden Spannungsversorgung (4) und einem steuerabhängig von einem Ansprechkreis (9) die Reihenschaltung kurzschließenden elektronischen Schalter (13) und einer Speiseschaltung zur Erzeugung einer Hilfsspannung für den Ansprechkreis, bestehend aus einem parallel zur Spannungseinspeisung des Ansprechkreises liegenden Kondensator (17) und einem mit diesem in Reihe liegenden elektronischen Spannungsregler (14), wobei die Reihenschaltung aus Kondensator und Spannungsregler parallel zum elektronishen Shalter liegt, **dadurch gekennzeichnet, daß** die Spannungsversorgung als kontinuierliche Gleichspannung (4) ausgebildet ist, daß eine die Kondensatorspannung erfassende Vergleichsschaltung (18) mit dem Steueranschluß (20) des als Transistor (13) ausgeführten elektronischen Schalters in Wirkverbindung steht und die Vergleichsschaltung (18) bei Unterschreiten einer vorbestimmten unteren Kondensatorspannung (VCL) den Transistor (13) bis zum Erreichen einer vorbestimmten oberen Kondensatorspannung (VCH) sperrt.

2. Näherungsschalter nach Anspruch 1, **dadurch gegekennzeichnet**, daß die Vergleichsschaltung (18) mit einer Hystereseschaltung versehen ist.

3. Näherungsschalter nach Anspruch 1 oder 2, **dadurchgekennzeichnet**, daß die Vergleichsschaltung aus einer Reihenschaltung von Widerstand (24), Zenerdiode (22) und Basis-Emitter-Strecke des Transistors (23) besteht, zu dessen Emitter-Kollektor-Strecke die Reihenschaltung eines weiteren Widerstandes (30) mit der Emitter-Basis-Strecke eines zweiten Transistors (26) liegt, wobei parallel zu dem weiteren Widerstand (30) die Emitter-Basis-Strecke eines Ausgangstransistors (29) liegt, dessen Kollektor am Steuereingang des Transistors (13) liegt und bei der der Kollektor des einen (23) mit der Basis des weiteren Transistors (26) und dieser Verbindungspunkt über einen Widerstand (25) am Eingang (19) der Vergleichsschaltung (18) liegt, der seinerseits über einen Widerstand (27) am Kollektor des weiteren Transistors (26) angeschlossen ist, wobei dieser Verbindungspunkt über einen Widerstand (28) am Verbindungspunkt zwischen Widerstand (24) und Zenerdiode (22) liegt.

4. Näherungsschalter nach Anspruch 3, **dadurch gegennzeichnet** , daß die Vergleichsschaltung (18) einerseits an der Basis eines den Spannungsregler (14) bildenden Transistors und andererseits am Minuspol (3, 12) der Speiseschaltung liegt.

5. Näherungsschalter nach einem der vorhergehenden Ansprüche, **dadurch gekennzeichnet** , daß zwischen Spannungsregler (14) und Transistor (13) eine Diode (32) geschaltet und der Verbindungspunkt zum Spannungsregler (14) nach außen geführt ist.

6. Näherungsschalter nach Anspruch 5, **dadurch gekennzeichnet**, daß zwischen Diode (32) und Spannungsregler (14) eine Lumineszenzdiode (34) mit parallel liegendem Widerstand (35) geschaltet ist.

## Claims

1. An electronic proximity switch having a voltage supply (4) connected in series with the load (5), and having an electronic switch (13) controllable in dependence on a response circuit (9) to short-circuit the series connection, and having a supply circuit for generating an auxiliary voltage for the response circuit, which supply circuit consists of a capacitor (17) connected in parallel with the voltage supply of the response circuit and an electronic voltage regulator (14) connected in series with the capacitor, the series connection of capacitor and voltage regulator being connected in parallel with the electronic switch, characterized in that the voltage supply is formed as a continuous direct voltage (4), in that a comparator circuit (18), detecting the capacitor voltage, is operatively connected with the control terminal (20) of the electronic switch, which switch is constituted by a transistor (13), and in that when the capacitor voltage falls below a predetermined lower capacitor voltage (VCL) the comparator circuit (18) disables the transistor (13) until a predetermined upper capacitor voltage (VCH) is reached.

2. A proximity switch according to claim 1, characterized in that the comparator circuit (18) is provided with a hysteresis circuit.

3. A proximity switch according to claim 1 or 2, characterized in that the comparator circuit consists of a series connection of a resistor (24), a Zener diode (22) and the base-emitter path of the transistor (23) whose emitter-collector path is connected to the series connection of a further resistor (30) with the emitter-base path of a second transistor (26), there being connected in parallel with the further resistor (30) the emitter-base path of an output transistor (29), the collector of which is connected to the control input of the transistor (13), and the collector of the one transistor (23) being connected to the base of the further transistor (26) and this connection node being connected by way of a resistor (25) to the input (19) of the comparator circuit (18), which for its part is connected by way of a resistor (27) to the collector of the further transistor (26), this connection node being connected by way of a resistor (28) to the connection node between the resistor (24) and the Zener diode (22).

4. A proximity switch according to claim 3, characterized in that the comparator circuit (18) is connected on the one hand to the base of a transistor forming the voltage regulator (14) and on the other hand to the negative terminal (3, 12) of the supply circuit.

5. A proximity switch according to one of the preceding claims, characterized in that a diode (32) is connected between the voltage regulator (14) and the transistor (13) and in that the connection node for the voltage regulator (14) is carried to the outside.

6. A proximity switch according to claim 5, characterized in that between the diode (32) and the voltage regulator (14) there is connected a light-emitting diode (34) with which a resistor (35) is connected in parallel.

## Revendications

1. Commutateur de proximité électronique, comprenant une alimentation en courant (4) en série avec la charge (5), et un commutateur électronique (13) qui court-circuite ce montage série en fonction d'un signal de commande fourni par un circuit de déclenchement (9), et un circuit d'alimentation destiné à produire une tension auxiliaire pour le circuit de déclenchement et composé d'un condensateur (17) monté en parallèle avec l'alimentation en courant du circuit de déclenchement, et d'un régulateur de tension électronique (14) en série avec ce condensateur, le montage en série du condensateur et du régulateur étant connecté en parallèle avec le commutateur électronique, caractérisé par le fait que l'alimentation en tension est appliquée sous la forme d'une tension continue permanente (4), qu'un circuit de comparaison (18), détectant la tension aux bornes du condensateur, est en liaison fonctionnelle avec la borne de commande (20) du commutateur électronique réalisé sous la forme d'un transistor (13) et que, dans le cas où la tension aux bornes du condensateur tombe au-dessous d'une tension inférieure prédéterminée (VCL), le circuit de comparaison (18) bloque le transistor (13) jusqu'à ce qu'une tension supérieure prédéterminée (VCH) aux bornes du condensateur soit atteinte.

2. Commutateur de proximité suivant la revendication 1, caractérisé par le fait que le circuit de comparaison (18) est pourvu d'un circuit à hystérésis.

3. Commutateur de proximité suivant la revendication 1 ou 2, caractérisé par le fait que le circuit de comparaison est formé d'un montage série d'une résistance (24), d'une diode Zener (22) et de la section base-émetteur du transistor (23), à la section émetteur-collecteur duquel est raccordé le montage série formé d'une autre résistance (30) et la section émetteur-base d'un second transistor (26), tandis qu'en parallèle avec l'autre résistance (30) est branchée la voie émetteur-base d'un transistor de sortie (29), dont le collecteur est raccordé à l'entrée de commande du transistor (13), le collecteur du premier transistor (23) étant relié à la base de l'autre transistor (26) et ce point de jonction étant raccordé au moyen d'une résistance (25) à l'entrée (19) du circuit de comparaison (18), qui pour sa part est relié par l'intermédiaire d'une résistance (27), au collecteur de l'autre transistor (26), ce point de jonction étant raccordé par l'intermédiaire d'une résistance (28) au point de jonction entre la résistance (24) et la diode Zener (22).

4. Commutateur de proximité suivant la revendication 3, caractérisé par le fait que le circuit de comparaison (18) est relié d'une part à la base d'un transistor constituant le régulateur de tension (14) et d'autre part au pôle négatif (3,12) du circuit d'alimentation.

5. Commutateur de proximité suivant l'une des revendications précédentes, caractérisé par le fait qu'une diode (32) est branchée entre le régulateur de tension (14) et le transistor (13) et que le point de jonction avec le régulateur de tension (14) est ressorti à l'extérieur.

6. Commutateur de proximité suivant la revendication 5, caractérisé par le fait qu'une diode à luminescence (34), en parallèle avec laquelle est branchée une résistance (35), est branchée entre la diode (32) et le régulateur de tension (14).

EP 0 078 511 B2

FIG 1

FIG 2

FIG 3

FIG 4

FIG 5